(19) Europäisches Patentamt
European Patent Office
Office européen des brevets

(11) **EP 3 798 655 A1**

(12) **EUROPÄISCHE PATENTANMELDUNG**

(43) Veröffentlichungstag:
**31.03.2021  Patentblatt 2021/13**

(21) Anmeldenummer: **19200140.2**

(22) Anmeldetag: **27.09.2019**

(51) Int Cl.:
*G01R 33/48* (2006.01)     *G01R 33/483* (2006.01)
*G01R 33/561* (2006.01)     *G01R 33/565* (2006.01)
*G01R 33/56* (2006.01)

(84) Benannte Vertragsstaaten:
**AL AT BE BG CH CY CZ DE DK EE ES FI FR GB
GR HR HU IE IS IT LI LT LU LV MC MK MT NL NO
PL PT RO RS SE SI SK SM TR**
Benannte Erstreckungsstaaten:
**BA ME**
Benannte Validierungsstaaten:
**KH MA MD TN**

(71) Anmelder: **Siemens Healthcare GmbH
91052 Erlangen (DE)**

(72) Erfinder:
• **Paul, Dominik
91088 Bubenreuth (DE)**
• **Kartäusch, Ralf
91088 Bubenreuth (DE)**
• **Zeller, Mario
91054 Erlangen (DE)**

(54) **BEWEGUNGSUNEMPFINDLICHE AUFNAHME VON MESSDATEN MITTELS MAGNETRESONANZTECHNIK**

(57)  Ein erfindungsgemäßes Verfahren zur Aufnahme von Messdaten eines Untersuchungsobjektes (U) mittels Magnetresonanztechnik umfasst die Schritte:
- Aufnehmen eines ersten Satzes an Messdaten eines Zielbereichs (Si) des Untersuchungsobjektes (U), wobei die Messdaten unter Schalten von konstanten Hauptauslesegradienten (HG) in einer Hauptausleserichtung (Gx) und durch Schalten von mindestens einem weiteren Auslesegradienten (WGy, WGz) mit modulierender Amplitude in einer auf die Hauptausleserichtung (Gx) senkrecht stehenden Richtung (Gy, Gz) gleichzeitig mit jedem Hauptauslesegradienten (HG) entlang erster k-Raumtrajektorien aufgenommen werden,
- Aufnehmen mindestens eines zweiten Satzes an Messdaten des Zielbereichs (Si) des Untersuchungsobjekts (U), wobei die Messdaten eines zweiten Satzes an Messdaten unter Schalten der gleichen Hauptauslesegradienten (HG') in den jeweiligen Hauptausleserichtungen (Gx) wie bei dem ersten Satz an Messdaten, und durch Schalten von mindestens einem weiteren Auslesegradienten (WGy', WGz') mit modulierender Amplitude in einer auf die Hauptausleserichtung (Gx) senkrecht stehenden Richtung (Gy, Gz) gleichzeitig mit jedem Hauptauslesegradienten (HG') entlang veränderter k-Raumtrajektorien aufgenommen werden,
- Rekonstruieren mindestens eines Bilddatensatzes (BD) aus dem ersten Satz an Messdaten und mindestens einem zweiten Satz an Messdaten.

FIG 3

EP 3 798 655 A1

**Beschreibung**

Die Erfindung betrifft eine bewegungsunempfindliche Aufnahme von Messdaten mittels Magnetresonanztechnik.

Die Magnetresonanz-Technik (im Folgenden steht die Abkürzung MR für Magnetresonanz) ist eine bekannte Technik, mit der Bilder vom Inneren eines Untersuchungsobjektes erzeugt werden können. Vereinfacht ausgedrückt wird hierzu das Untersuchungsobjekt in einem Magnetresonanzgerät in einem vergleichsweise starken statischen, homogenen Grundmagnetfeld, auch $B_0$-Feld genannt, mit Feldstärken von 0,2 Tesla bis 7 Tesla und mehr positioniert, so dass sich dessen Kernspins entlang des Grundmagnetfeldes orientieren. Zum Auslösen von Kernspinresonanzen werden hochfrequente Anregungspulse (RF-Pulse) in das Untersuchungsobjekt eingestrahlt, die ausgelösten Kernspinresonanzen als sogenannte k-Raumdaten gemessen und auf deren Basis MR-Bilder rekonstruiert oder Spektroskopiedaten ermittelt. Zur Ortskodierung der Messdaten werden dem Grundmagnetfeld schnell geschaltete magnetische Gradientenfelder, kurz Gradienten genannt, überlagert. Ein verwendetes Schema, das eine zeitliche Abfolge von einzustrahlenden RF-Pulsen und zu schaltenden Gradienten beschreibt, wird als Pulssequenz(schema) bezeichnet. Die aufgezeichneten Messdaten werden digitalisiert und als komplexe Zahlenwerte in einer k-Raum-Matrix abgelegt. Aus der mit Werten belegten k-Raum-Matrix ist z.B. mittels einer mehrdimensionalen FourierTransformation ein zugehöriges MR-Bild rekonstruierbar.

Sogenannte parallele Akquisitionstechniken (ppa), wie z.B. GRAPPA ("GeneRalized Autocalibrating Partially Parallel Acquisition") oder SENSE ("Sensitivity Encoding"), bei denen mit Hilfe von mehreren RF-Spulen nur eine gemäß dem Nyquist-Theorem im k-Raum unterabgetastete Anzahl an Messdaten aufgenommen werden, werden eingesetzt, um z.B. die für die Aufnahme der Messdaten insgesamt nötige Messzeit zu verkürzen oder die Auflösung zu erhöhen. Die "fehlenden", d.h. nicht gemessenen aber für einen gemäß Nyquist vollständigen Satz an Messdaten erforderlichen, Messdaten werden hierbei auf Basis von Sensitivitätsdaten der verwendeten RF-Spulen und Kalibrierungsdaten und den gemessenen Messdaten ergänzt.

Der Wunsch nach immer schnelleren MR-Aufnahmen im klinischen Umfeld führt auf der anderen Seite zu einer Renaissance von Verfahren, bei denen mehrere Bilder simultan aufgenommen werden. Allgemein lassen sich diese Verfahren dadurch charakterisieren, dass zumindest während eines Teils der Messung gezielt Transversalmagnetisierung von zumindest zwei Schichten gleichzeitig für den Bildgebungsprozess genutzt wird ("Multi-Schicht-Bildgebung", "Schicht-Multiplexing", "Simultaneous Multi-Slice" (SMS)). Im Gegensatz dazu wird bei der etablierten "Mehrschicht-Bildgebung" das Signal von zumindest zwei Schichten alternierend, d. h. vollständig unabhängig voneinander mit entsprechender längerer Messzeit aufgenommen.

Bekannte SMS-Verfahren sind beispielsweise Verfahren, die Verfahren aus der oben genannten Bildgebung mittels ppa, bei welchen Wissen über die Sensitivitätsverteilung der bei dem Erfassen der Messdaten eingesetzten Empfangsspulen als zusätzliche Information genutzt wird, um gemäß Nyquist unterabgetastete Messdaten aufzufüllen, in Schicht-Richtung einsetzen, um überlagert aus mehreren Schichten aufgenommene Signale in Signale der einzelnen Schichten zu separieren. Zu diesen Verfahren gehören beispielsweise auch die CAIPIRINHA-Technik, wie sie von Breuer et al. in "Controlled Aliasing in Parallel Imaging Results in Hiher Acceleration (CAIPIRINHA) for Multi-Slice Imaging", Magnetic Resonance in Medicine 53, 2005, S. 684-691 beschrieben ist, und die blipped CAIPIRINHA-Technik, wie sie von Setsompop et al. in "Blipped-Controlled Aliasing in Parallel Imaging for Simultaneous Multislice Echo Planar Imaging With Reduced g-Factor Penalty", Magnetic Resonance in Medicine 67, 2012, S. 1210-1224, beschrieben wird, wobei der im letztgenannten Titel genannte g-Faktor ("gfactor", kurz für "Geometrie-Faktor") ein Maß für eine Trennbarkeit der verschiedenen verwendeten Empfangsspulen darstellt.

Als ein Verfahren diesen g-Faktor weiter zu reduzieren ist es für CAIPIRINHA-Verfahren weiterhin bekannt, die Auslesetrajektorien im k-Raum, und damit das Akquisitionsschema, derart zu verändern, dass die Messdaten entlang von wellenförmig oder schraubenförmig verlaufenden Auslesetrajektorien erfasst werden. Dies ist beispielsweise in der US8981776B2, in dem Artikel von Bilgic et al. "Wave-CAIPI for Highly Accelerated 3D Imaging", Magnetic Resonance in Medicine 73:2152-2162 (2015), oder, für zweidimensionale (2D) Bildgebung in Chen et al. "Self-Calibrating Wave-Encoded Variable-Density Single-Shot Fast Spin Echo Imaging", J. Magn. Reson. Imaging 2018;47:954-966, oder auch für Spinecho(SE)-Verfahren in Gagoski et al. "RARE/Turbo Spin Echo Imaging with Simultaneous Multislice Wave-CAIPI", Magn. Reson. Med. 73:929-938 (2015) beschrieben.

Der Erfindung liegt die Aufgabe zugrunde, eine schnelle und bewegungsunempfindliche Aufnahme von Messdaten eines Untersuchungsobjektes mittels Magnetresonanztechnik zu ermöglichen.

Die Aufgabe wird gelöst durch ein Verfahren zur Aufnahme von Messdaten eines Untersuchungsobjektes mittels Magnetresonanztechnik gemäß Anspruch 1, eine Magnetresonanzanlage gemäß Anspruch 9, ein Computerprogramm gemäß Anspruch 10, sowie einen elektronisch lesbaren Datenträger gemäß Anspruch 11.

Ein erfindungsgemäßes Verfahren zur Aufnahme von Messdaten eines Untersuchungsobjektes mittels Magnetresonanztechnik umfasst die Schritte:

- Aufnehmen eines ersten Satzes an Messdaten eines Zielbereichs des Untersuchungsobjektes, wobei die Messdaten unter Schalten von konstanten Hauptauslesegradienten in einer Hauptausleserichtung und durch Schalten von mindestens einem weiteren Auslesegradienten mit modulierender Amplitude in einer auf die Hauptausleserichtung senkrecht stehenden Richtung gleichzeitig mit jedem Hauptauslesegradienten entlang erster k-Raumtrajektorien aufgenommen werden,

- Aufnehmen mindestens eines zweiten Satzes an Messdaten des Zielbereichs des Untersuchungsobjekts, wobei die Messdaten eines zweiten Satzes an Messdaten unter Schalten der gleichen Hauptauslesegradienten in den jeweiligen Hauptausleserichtungen wie bei dem ersten Satz an Messdaten, und durch Schalten von mindestens einem weiteren Auslesegradienten mit modulierender Amplitude in einer auf die Hauptausleserichtung senkrecht stehenden Richtung gleichzeitig mit jedem Hauptauslesegradienten entlang veränderter k-Raumtrajektorien aufgenommen werden,
- Rekonstruieren mindestens eines Bilddatensatzes (BD) aus dem ersten Satz an Messdaten) und mindestens einem zweiten Satz an Messdaten.

Durch die erfindungsgemäß wiederholte Aufnahme von Messdaten eines Zielbereichs eines Untersuchungsobjektes können möglicherweise unterschiedliche Bewegungszustände des Zielbereichs des Untersuchungsobjekts in den unterschiedlichen Aufnahmen der Messdaten, z.B. durch ein Mittelungsverfahren, das die Messdaten der verschiedenen Aufnahmen miteinander kombiniert, vorteilhaft verschmiert werden, sodass aus den kombinierten Messdaten rekonstruierte Bilddaten bewegungsunempfindlich sind. Die verbessert die Qualität der erhaltenen Bilddaten, insbesondere bei ansonsten bewegungsempfindlichen Aufnahmearten, z.B. mittels einer (Turbo-)Spin-Echo-Sequenz ((T)SE-Sequenz) etwa bei Zielbereichen im Abdomen eines Patienten als Untersuchungsobjekt. Des Weiteren können FID-Artefakte (FID: freier Induktionsabfall, engl. "free induction decay") durch eine derartige Mittelung reduziert werden, wie sie z.B. bei Aufnahmen von Messdaten mittels einer SPACE-Sequenz (SPACE: engl. "Sampling Perfection with Application optimized Contrasts using different flip angle Evolutions") auftreten können. Durch die Veränderung der in den verschiedenen Wiederholungen von Aufnahmen von Messdaten verwendeten k-Raumtrajektorien können verschiedene Bewegungszustände besser verschmiert werden und FID-Artefakte vollständig vermieden werden. Somit wird die Bildqualität, der aus den wiederholt aufgenommenen Messdaten gewonnenen Bilddaten, weiter erhöht.

Eine erfindungsgemäße Magnetresonanzanlage umfasst eine Magneteinheit, eine Gradienteneinheit, eine Hochfrequenzeinheit und eine zur Durchführung eines erfindungsgemäßen Verfahrens ausgebildete Steuereinrichtung mit einer Abtastwegänderungseinheit.

Ein erfindungsgemäßes Computerprogramm implementiert ein erfindungsgemäßes Verfahren auf einer Steuereinrichtung, wenn es auf der Steuereinrichtung ausgeführt wird.

Das Computerprogramm kann hierbei auch in Form eines Computerprogrammprodukts vorliegen, welches direkt in einen Speicher einer Steuereinrichtung ladbar ist, mit Programmcode-Mitteln, um ein erfindungsgemäßes Verfahren auszuführen, wenn das Computerprogrammprodukt in der Recheneinheit des Rechensystems ausgeführt wird.

Ein erfindungsgemäßer elektronisch lesbarer Datenträger umfasst darauf gespeicherte elektronisch lesbare Steuerinformationen, welche zumindest ein erfindungsgemäßes Computerprogramm umfassen und derart ausgestaltet sind, dass sie bei Verwendung des Datenträgers in einer Steuereinrichtung einer Magnetresonanzanlage ein erfindungsgemäßes Verfahren durchführen.

Die in Bezug auf das Verfahren angegebenen Vorteile und Ausführungen gelten analog auch für die Magnetresonanzanlage, das Computerprogrammprodukt und den elektronisch lesbaren Datenträger.

Weitere Vorteile und Einzelheiten der vorliegenden Erfindung ergeben sich aus den im Folgenden beschriebenen Ausführungsbeispielen sowie anhand der Zeichnungen. Die aufgeführten Beispiele stellen keine Beschränkung der Erfindung dar. Es zeigen:

Fig. 1    ein schematisches Ablaufdiagramm eines erfindungsgemäßen Verfahrens,

Fig. 2    schematisch einen Teil einer Sequenz zur erfindungsgemäßen Erfassung von Messdaten in einer ersten Wiederholung,

Fig. 3    schematisch einen Teil einer Sequenz zur erfindungsgemäßen Erfassung von Messdaten in einer weiteren Wiederholung,

Fig. 4    eine schematisch dargestellte erfindungsgemäße Magnetresonanzanlage.

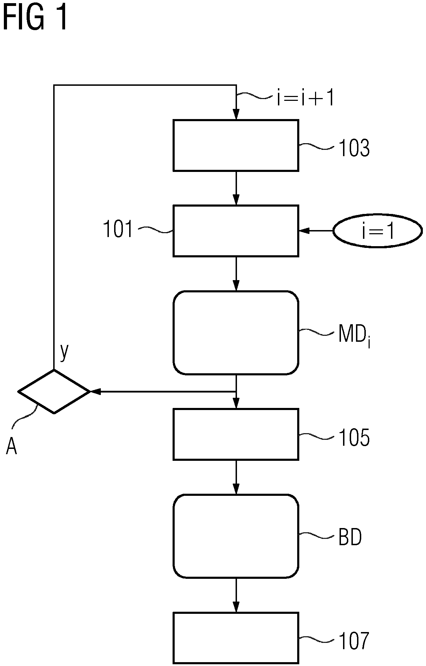

Figur 1 ist ein schematisches Ablaufdiagramm eines erfindungsgemäßen Verfahrens zur Aufnahme von Messdaten eines Untersuchungsobjektes mittels Magnetresonanztechnik.

Dabei wird in einer ersten Wiederholung (i=1) ein erster Satz an Messdaten ($MD_i$, mit i=1) eines Zielbereichs, z.B. einer Schicht oder eines Slabs, des Untersuchungsobjektes aufgenommen, wobei die Messdaten unter Schalten von konstanten Hauptauslesegradienten in einer Hauptausleserichtung und durch Schalten von mindestens einem weiteren Auslesegradienten mit modulierender Amplitude in einer auf die Hauptausleserichtung senkrecht stehenden Richtung gleichzeitig mit jedem Hauptauslesegradienten entlang erster k-Raumtrajektorien aufgenommen werden (Block 101).

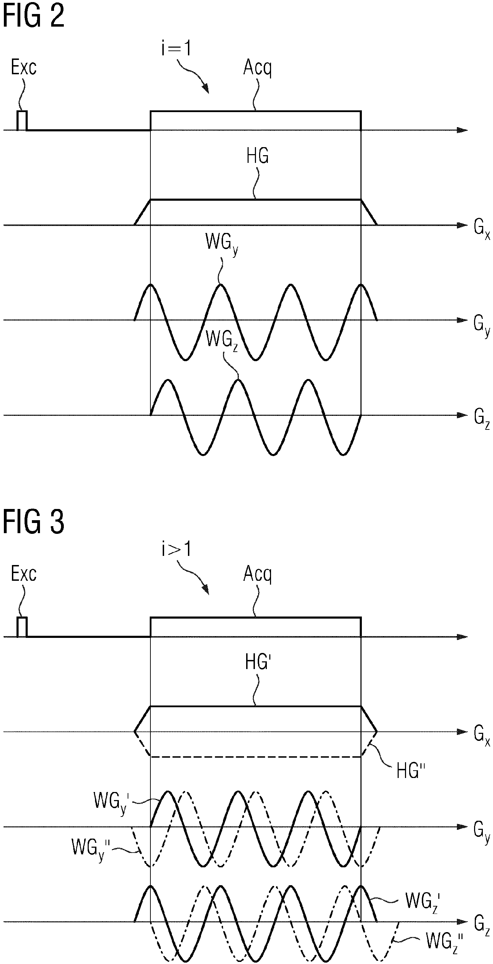

In Figur 2 ist schematisch ein Teil einer Sequenz zur erfindungsgemäßen Erfassung von Messdaten $MD_i$ in einer ersten Wiederholung i=1 im zeitlichen Verlauf dargestellt.

Um Messdaten eines Zielbereichs eines Untersuchungsobjekts aufzunehmen, werden auf übliche Weise Spins in dem Zielbereich mittels einer Anregung Exc angeregt und die durch die Anregung Exc erzeugten Echosignale in einer Auslesezeitspanne Acq als Messdaten aufgenommen. Während der Auslesezeitspanne Acq werden zur räumlichen Kodierung Auslesegradienten HG, $WG_y$, $WG_z$ geschaltet, die die k-Raumtrajektorie festlegen, entlang derer die in einer Auslesezeitspanne Acq aufgenommenen Messdaten abgetastet werden. In dem dargestellten Beispiel wird in einer Hauptausleserichtung Gx ein Hauptauslesegradient HG geschaltet, der während der Auslesezeitspanne Acq eine konstante Amplitude aufweist. Gleichzeitig mit dem Hauptauslesegradienten HG, also ebenfalls während der Auslesezeitspanne Acq, wird mindestens ein weiterer Auslesegradient $WG_y$ und/oder $WG_z$ geschaltet, wobei weitere Auslesegradienten eine, z.B. zwischen einem positivem Wert einer maximalen Amplitude und dem negativen Wert der maximalen Amplitude, modulierende Amplitude aufweisen und in einer auf die Hauptausleserichtung $G_x$ senkrecht stehenden Richtung $G_y$ bzw. $G_z$ geschaltet werden. Die Richtungen $G_y$ und $G_z$ stehen hierbei ebenfalls senkrecht zueinander. Dadurch ergibt sich eine erste k-Raumtrajektorie, die im k-Raum in der der Hauptausleserichtung $G_x$ entsprechenden Richtung $k_x$ verläuft und dabei ebenfalls entsprechend der Modulation der geschalteten weiteren Auslesegradienten $WG_y$ und $WG_z$ um die Richtung kx moduliert. Die Modulation der k-Raumtrajektorie um die der Hauptausleserichtung $G_x$ entsprechenden Richtung $k_x$ ist hierbei z.B. wellenförmig (wenn nur ein weiterer Auslesegradient $WG_y$ oder $WG_z$ geschaltet wird) oder schraubenförmig (wenn zwei weitere Auslesegradienten $WG_y$ und $WG_z$ geschaltet werden).

Die Modulation eines weiteren Auslesegradienten WGy oder WGz kann beispielsweise sinusförmig, wie bei Wave-Kodierungen, z.B. Wave-CAIPI, üblich, sein, bei welchen Auslesegradienten mit, z.B. sinusförmigen, Modulationen in zwei Gradientenrichtungen (z.B. auf zwei Gradientenachsen) ausgespielt werden, während auf in der dritten Gradientenrichtung (z.B. der dritten Gradientenachse) ein linearer Gradient angelegt wird, um eine schraubenförmige Auslese-k-Raumtrajektorie zu erzeugen. Werden mehr als eine weiteren Auslesegradient $WG_y$ und $WG_z$ geschaltet, und ist ein schraubenförmiger Verlauf der k-Raumtrajektorie um die Richtung kx gewünscht, sollten die Modulationen der beiden weiteren Auslesegradienten $WG_y$ und $WG_z$ zu Beginn der Auslesezeitspanne Acq an unterschiedlichen Phasen der jeweiligen Modulation geschaltet werden. In dem dargestellten Beispiel haben die weiteren Auslesegradienten $WG_y$ und $WG_z$ eine selbe, sinusförmige Modulation, jedoch zu Beginn der Auslesezeitspanne Acq einen Phasenversatz von 90°. Eine Aufnahme von Messdaten kann insbesondere mittels einer WAVE-CAIPI-Technik erfolgen, wodurch besonders kurze Messzeiten für die insgesamte Aufnahme eines Satzes an Messdaten erreicht werden können.

Um einen Satz an Messdaten eines Zielbereichs eines Untersuchungsobjekts aufzunehmen, aus dem Bilddaten des Zielbereichs rekonstruiert werden können, wird das in Figur 2 dargestellte Schema auf übliche Weise so oft, z.B. mit unterschiedlicher Phasenkodierung durch Schalten verschiedener Gradienten in Phasenkodierrichtung (nicht dargestellt) zwischen der Anregung Exc und der Auslesezeitspanne Acq oder auch mit unterschiedlichen Hauptausleserichtungen $G_x$ wiederholt, bis ein für die Rekonstruktion der gewünschten Bilddaten ausreichender Satz an Messdaten aufgenommen wurde.

Sind so alle Messdaten eines Satzes an Messdaten aufgenommen wird in einer Abfrage A überprüft, ob bereits alle gewünschten Sätze an Messdaten, z.B. von insgesamt n (n ≥ 2) gewünschten Wiederholungen, aufgenommen wurden (i=n), oder ob noch eine Wiederholung der Aufnahme eines Satzes an Messdaten erfolgen soll (A, "y").

Zumindest einmal wird eine weitere Wiederholung durchgeführt, da zumindest ein zweiter Satz an Messdaten $MD_i$, mit i>1, des Zielbereichs aufgenommen wird. Dazu wird der Zähler i der Wiederholungen um Eins erhöht (i=i+1) und es werden die für die Wiederholung i zu schaltenden Hauptauslesegradienten und weiteren Auslesegradienten derart bestimmt, dass die Messdaten des mindestens einen zweiten Satzes an Messdaten $MD_i$, mit i>1, entlang erfindungsgemäß veränderter k-Raumraumtrajektorien aufgenommen werden (Block 103), sodass die Messdaten eines zweiten Satzes an Messdaten $MD_i$, mit i>1, bei einem erneuten Durchlauf des Blocks 101 unter Schalten der gleichen Hauptauslesegradienten in den jeweiligen Hauptausleserichtungen wie bei dem ersten Satz an Messdaten, und durch Schalten von mindestens einem weiteren Auslesegradienten mit modulierender Amplitude in einer auf die Hauptausleserichtung senkrecht stehenden Richtung gleichzeitig mit jedem Hauptauslesegradienten entlang veränderter k-Raumtrajektorien aufgenommen werden.

In Figur 3 ist schematisch ein Teil einer Sequenz zu Beispielen einer erfindungsgemäßen Erfassung von Messdaten $MD_i$ in einer weiteren Wiederholung i>1 im zeitlichen Verlauf dargestellt.

In wesentlichen Teilen entspricht die in Figur 3 dargestellte Sequenz der in Figur 2 dargestellten, weshalb gleiche Komponenten mit gleichen Bezugszeichen versehen sind, wie die Anregung Ecx und die Auslesezeitspanne Acq, die für die in den Figuren 2 und 3 gezeigten Fälle gleich ausgestaltet sind. Jedoch unterscheiden sich die Figuren 2 und 3 in zumindest einem der während der Auslesezeitspanne Acq geschalteten Auslesegradienten HG', HG", $WG_y$', $WG_y$", $WG_z$', $WG_z$", um die Messdaten entlang einer veränderten k-Raumtrajektorie aufzunehmen.

Dabei können z.B. veränderte k-Raumtrajektorien eine veränderte Orientierung gegenüber zugehörigen ersten k-Raumtrajektorien des entsprechenden Hauptauslesegradienten haben. Dies kann dadurch erreicht werden, dass die Polarität des Hauptauslesegradienten HG, der während einer Aufnahme von Messdaten eines ersten Satzes an Messdaten $MD_i$, mit i=1, (siehe Figur 2) bei der Aufnahme von Messdaten eines zweiten Satzes an Messdaten $MD_i$, mit i>1, umgekehrt wird (bei gleicher Amplitude), sodass bei der Aufnahme von Messdaten eines zweiten Satzes an Messdaten $MD_i$, mit i>1, ein Hauptauslesegradient HG" geschaltet wird, sodass der k-Raum in einer gegenüber der Aufnahme von Messdaten eines ersten Satzes an Messdaten $MD_i$, mit i=1, entgegengesetzten Richtung durchlaufen wird, mithin die veränderte k-Raumtrajektorie eine andere Orientierung als die zugehörige erste k-Raumtrajektorie.

Unter einer zu einer veränderten k-Raumtrajektorie zugehörigen ersten k-Raumtrajektorie wird hierbei jeweils diejenige veränderte k-Raumtrajektorie verstanden, die sich nur durch mindestens einen geänderten Auslesegradienten HG', HG", $WG_y$', $WG_y$", $WG_z$', $WG_z$" von der zugehörigen ersten k-Raumtrajektorie unterscheidet, ansonsten jedoch durch eine gleiche Sequenz (insbesondere Anregung und Phasenkodierung) erzeugt wird.

Durch die veränderte Orientierung wird der k-Raum mit der veränderten k-Raumtrajektorie in im Vergleich zu der zugehörigen ersten k-Raumtrajektorie in der der Hauptausleserichtung $G_x$ im k-Raum entsprechender Richtung $k_x$ in entgegengesetzter Weise (Orientierung) durchlaufen. D.h. wird in einer ersten k-Raumtrajektorie der k-Raum in Richtung $k_x$ beispielsweise von einem Startwert -k bis zu einem Endwert k abgetastet, wird der k-Raum mit der veränderten k-Raumtrajektorie mit veränderter Orientierung in Richtung $k_x$ von einem Startwert k bis zu einem Endwert -k abgetastet.

Ist in einer veränderten k-Raumtrajektorie gegenüber der zugehörigen ersten k-Raumtrajektorie nur die Orientierung verändert, wird damit die Abtastreihenfolge der auf der veränderten k-Raumtrajektorie abgetasteten k-Raumpunkte gegenüber der entsprechenden ersten k-Raumtrajektorie umgekehrt.

Durch verwenden einer veränderten Orientierung für eine veränderte k-Raumtrajektorie im Vergleich zu einer zugehörigen ersten k-Raumtrajektorie kann ein durch den im Verlauf der Auslesezeitspanne erfolgenden T2*-Zerfall erfolgender Abfall der Signalintensitäten der nacheinander entlang einer ersten k-Raumtrajektorie aufgenommenen Messdaten eines ersten Satzes an Messdaten mit Hilfe der entlang einer zugehörigen veränderten k-Raumtrajektorie mit veränderter Orientierung aufgenommenen Messdaten eines weiteren Satzes an Messdaten kompensiert werden.

In einem einfachen Beispiel mit zwei Wiederholungen (n=2) können die Formen der Auslesegradienten HG, $WG_y$ und $WG_z$ für die k-Raumrichtungen $k_x$, $k_y$ und $k_z$ wie folgt für die Dauer des Auslesezeitfensters Acq berechnet werden:

Für die erste Wiederholung zur Aufnahme des ersten Satzes an Messdaten $MD_i$, i=1:

$$kz(t) = \sin(at),$$

$$ky(t) = \cos(at),$$

$$kx(t) = g, \text{ mit } g = \text{konstant}.$$

Damit wird eine gemäß der durch sin (at) = cos (at - 90°) festgelegten Modulation über der Zeit t schraubenförmig in kx-Richtung verlaufende k-Raumtrajektorie erzeugt.

Für die zweite Wiederholung zur Aufnahme des zweiten Satzes an Messdaten $MD_i$, i=2:

$$kz(t) = \sin(at),$$

$$ky(t) = \cos(at),$$

$$kx(t) = -g.$$

Damit wird eine gemäß der durch sin (at) = cos (at - 90°) festgelegten Modulation über der Zeit t schraubenförmig in kx-Richtung verlaufende k-Raumtrajektorie jedoch in im Vergleich zu der Wiederholung i=1 entgegengesetzter Durchlaufrichtung (Orientierung).

Zusätzlich oder alternativ können veränderte k-Raumtrajektorien eine um eine Phase verschobene Modulation der Amplitude der geschalteten weiteren Auslesegradienten $WG_y$', $WG_z$', $WG_y$", $WG_z$" gegenüber der Modulation der Amplitude der weiteren Auslesegradienten $WG_y$, $WG_z$ (Figur 2) der jeweils zugehörigen ersten k-Raumtrajektorie aufweisen.

Wird die Orientierung einer veränderten k-Raumtrajektorie nicht gegenüber der zugehörigen ersten k-Raumtrajektorie verändert, wird in Hauptausleserichtung Gx ein dem Hauptauslesegradienten HG (Figur 2) gleicher Hauptauslesegradient HG' geschaltet.

In einem einfachen Beispiel mit n Wiederholungen hierzu können die Formen der Auslesegradienten HG, $WG_y$ und $WG_z$ für die k-Raumrichtungen $k_x$, $k_y$ und $k_z$ wie folgt für die Dauer des Auslesezeitfensters Acq berechnet werden:

Für die erste Wiederholung zur Aufnahme des ersten Satzes an Messdaten $MD_i$, i=1:

$$kz(t) = \sin(at),$$

$$ky(t) = \cos(at),$$

$$kx(t) = g, \text{ mit } g \text{ konstant}.$$

Damit wird eine gemäß der durch sin (at) = cos (at - 90°) festgelegten Modulation über der Zeit t schraubenförmig in kx-Richtung verlaufende k-Raumtrajektorie erzeugt.

Für eine zweite Wiederholung zur Aufnahme eines zweiten Satzes an Messdaten $MD_i$, i>1:

$$kz(t) = \sin(at + b_i)$$

$$ky(t) = \cos(at + b_i)$$

$$kx(t) = (\pm)g, \text{ mit } g \text{ konstant}.$$

Damit wird eine gemäß der durch sin (at) = cos (at - 90°) festgelegten Modulation über der Zeit t schraubenförmig in kx-Richtung verlaufende mit der k-Raumtrajektorie der Wiederholung i=1 verschachtelte k-Raumtrajektorie erzeugt. Je nach Wahl des Vorzeichens für kx(t) wird die Orientierung wie bereits oben beschrieben geändert (-) oder nicht (+).

Als Beispiele für verschobene Phasen der Modulation der Amplituden der weiteren Auslesegradienten $WG_y$ und $WG_z$ (Figur 2) sind in Figur 3 beispielhaft weitere Auslesegradienten $WG_y'$ und $WG_z'$ mit einer gegenüber den weiteren Auslesegradienten $WG_y$ und $WG_z$ (Figur 2) um eine Phase von 90° verschobenen Modulation und als weiteres Beispiel weitere Auslesegradienten $WG_y''$ und $WG_z''$ mit einer gegenüber den weiteren Auslesegradienten $WG_y$ und $WG_z$ (Figur 2) um eine Phase von 180° verschobenen Modulation dargestellt.

Die veränderten k-Raumtrajektorien liegen somit, wenn nur ein weiterer Auslesegradient $WG_y'$, $WG_y''$ oder $WG_z'$, $WG_z''$ geschaltet wird, in demselben durch die Hauptausleserichtung $G_x$, die auf die Hauptausleserichtung senkrecht stehende Richtung $G_y$ oder $G_z$, in die der weitere Auslesegradient $WG_y'$, $WG_y''$ oder $WG_z'$, $WG_z''$ geschaltet wird, sowie die Amplituden des Hauptauslesegradienten HG, HG', HG" und des weiteren Auslesegradienten $WG_y'$, $WG_y''$ oder $WG_z'$, $WG_z''$ festgelegten Streifen in der auch die zugehörige erste k-Raumtrajektorie (z.B. wellenförmig) liegt, bzw. wenn zwei weitere Auslesegradienten $WG_y'$, $WG_y''$ und $WG_z'$, $WG_z''$ geschaltet werden, in demselben durch die Hauptausleserichtung $G_x$, die auf die Hauptausleserichtung senkrecht stehenden Richtungen $G_y$ und $G_z$, in die die weiteren Auslesegradienten $WG_y'$, $WG_y''$ und $WG_z'$, $WG_z''$ geschaltet werden, sowie die Amplituden des Hauptauslesegradienten HG, HG', HG" und der weiteren Auslesegradienten $WG_y'$, $WG_y''$ und $WG_z'$, $WG_z''$ festgelegten Zylinder in dem auch die zugehörige erste k-Raumtrajektorie (z.B. schraubenförmig) liegt.

Die bei einer Aufnahme von Messdaten eines zweiten Satzes an Messdaten $MD_i$, mit i>1, für eine Wiederholung i anzuwendenden versetzten Phasen können z.B. in Abhängigkeit einer Anzahl (n-1) an zweiten Sätzen an Messdaten $MD_i$, mit i>1, bestimmt werden, insbesondere derart, dass für jede Wiederholung durch die jeweiligen Phasen ein anderer Versatz der jeweiligen Modulation erzeugt wird.

Beispielsweise kann für eine Wiederholung i von insgesamt n Wiederholungen eine Phase b nach der folgenden Regel bestimmt werden:

$$b_i = (i-1)*360°/n.$$

Bei einer derartigen Wahl der Phasen $b_i$ für jede Wiederholung i werden die Phasen bi automatisch derart bestimmt, dass sich eine erste k-Raumtrajektorie und zugehörige veränderte k-Raumtrajektorien durch die jeweiligen Phasen möglichst stark voneinander unterscheiden. Damit werden in jeder Wiederholung andere k-Raumpunkte bei der Aufnahme der Messdaten der verschiedenen aufzunehmenden Sätze an Messdaten abgetastet, wodurch die Bildqualität der aus den Messdaten rekonstruierten Bilddaten erhöht.

Weiterhin kann es sinnvoll sein, insbesondere bei mehr als 2 Wiederholungen n (n>2) eine Reihenfolge, in welcher der erste Satz an Messdaten $MD_i$, mit i=1, und der mindestens eine zweite Satz an Messdaten $MD_i$, mit n≥i>1, zeitlich nacheinander aufgenommen werden, in Abhängigkeit der bei der Aufnahme der zweiten Sätze an Messdaten $MD_i$, mit i>1, angewendeten Phasen $b_i$ festgelegt wird. Auf diese Weise kann eine Art Verschachtelung (engl. "interleaving") der Wiederholungen erfolgen, damit die verschiedenen Phasen $b_i$ nicht in einer konsekutiven Reihenfolge, z.B. ihrer Größe nach geordnet, sondern in einer nicht-linearen Reihenfolge angewendet werden, um z.B. Übersprecheffekte zu vermeiden. Beispielsweise im Fall von vier Wiederholugen n=4 mit anzuwendenden Phasen $b_1$ = 0°, $b_2$ = 90°, $b_3$ = 180°, $b_4$ = 270° können die Wiederholungen in einer Reihenfolge durchgeführt werden, dass die in zeitlich aufeinanderfolgenden Wiederholungen angewendeten Phasen z.B. die folgende Reihenfolge haben: 0° - 180° - 90° - 270°.

Mit dem erfindungsgemäßen Verfahren zur Aufnahme eines ersten Satzes an Messdaten $MD_i$, mit i=1, entlang erster k-Raumtrajektorien und mindestens eines zweiten Satzes an Messdaten $MD_i$, mit i>1 entlang veränderter k-Raumtrajektorien wird eine Bewegungsempfindlichkeit der Aufnahmen reduziert und während der durchgeführten Wiederholungen vorliegende verschiedene Bewegungszustände des Zielgebiets des Untersuchungsobjektes können effektiv verschmiert werden, sodass aus den aufgenommenen Messdaten Bilddaten mit reduzierter Bewegungsempfindlichkeit und damit verbesserter Bildqualität rekonstruiert werden können. Auch FID-Artefakte lassen sich durch das erfindungsgemäße Verfahren der Aufnahme von Messdaten entlang von veränderten k-Raumtrajektorien besonders effektiv reduzieren.

Aus dem aufgenommenen ersten Satz an Messdaten $MD_i$, mit i=1, und mindestens einem aufgenommenen zweiten Satz an Messdaten $MD_i$, mit i>1, kann mindestens ein Bilddatensatz BD rekonstruiert werden (Block 105). Durch die Rekonstruktion des mindestens einen Bilddatensatzes auf Basis von somit mindestens zwei erfindungsgemäßen Sätzen an Messdaten des Zielbereichs, welche entlang veränderter k-Raumtrajektorien aufgenommen wurden, wird die Bildqualität eines rekonstruierten Bilddatensatzes erhöht. Dabei können die Messdaten der verschiedenen Sätze an Messdaten beispielsweise miteinander kombiniert werden bevor aus den kombinierten Messdaten Bilddaten rekonstruiert werden, oder es können aus den verschiedenen Sätzen an Messdaten zunächst je ein Bilddatensatz rekonstruiert werden, welche Bilddatensätze dann, z.B. mittels einem gängigen Mittelungsverfahren, zu einem Bilddatensatz BD verarbeitet werden. Rekonstruierte Bilddatensätze können, z.B. für eine weitere Verarbeitung, gespeichert und/der auf einem Anzeigegerät angezeigt werden (Block 107).

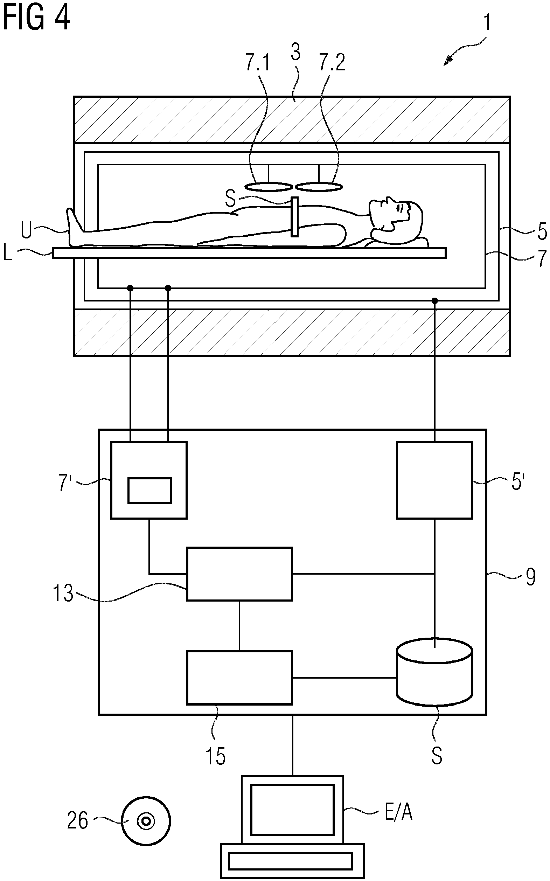

Figur 4 stellt schematisch eine erfindungsgemäße Magnetresonanzanlage 1 dar. Diese umfasst eine Magneteinheit 3 zur Erzeugung des Grundmagnetfeldes, eine Gradienteneinheit 5 zur Erzeugung der Gradientenfelder, eine Hochfrequenzeinheit 7 zur Einstrahlung und zum Empfang von Hochfrequenzsignalen und eine zur Durchführung eines erfindungsgemäßen Verfahrens ausgebildete Steuereinrichtung 9.

In der Figur 4 sind diese Teileinheiten der Magnetresonanzanlage 1 nur grob schematisch dargestellt. Insbesondere kann die Hochfrequenzeinheit 7 aus mehreren Untereinheiten, beispielsweise aus mehreren Spulen wie den schematisch gezeigten Spulen 7.1 und 7.2 oder mehr Spulen bestehen, die entweder nur zum Senden von Hochfrequenzsignalen oder nur zum Empfangen der ausgelösten Hochfrequenzsignale oder für beides ausgestaltet sein können.

Zur Untersuchung eines Untersuchungsobjektes U, beispielsweise eines Patienten oder auch eines Phantoms, kann dieses auf einer Liege L in die Magnetresonanzanlage 1 in deren Messvolumen eingebracht werden. Die Schicht oder der Slab $S_i$ stellt einen exemplarischen Zielbereich des Untersuchungsobjekts dar, aus dem Daten aufgenommen und damit erfasst werden sollen.

Die Steuereinrichtung 9 dient der Steuerung der Magnetresonanzanlage 1 und kann insbesondere die Gradienteneinheit 5 mittels einer Gradientensteuerung 5' und die Hochfrequenzeinheit 7 mittels einer Hochfrequenz-Sende-/Empfangs-Steuerung 7' steuern. Die Hochfrequenzeinheit 7 kann hierbei mehrere Kanäle umfassen, auf denen Signale gesendet oder empfangen werden können.

Die Hochfrequenzeinheit 7 ist zusammen mit ihrer Hochfrequenz-Sende-/Empfangs-Steuerung 7' für die Erzeugung und das Einstrahlen (Senden) eines Hochfrequenz-Wechselfeldes zur Manipulation der Spins in einem zu manipulierenden Bereich (beispielsweise in zu messenden Schichten S) des Untersuchungsobjekts U zuständig. Dabei wird die Mittenfrequenz des, auch als B1-Feld bezeichneten, Hochfrequenz-Wechselfeldes in aller Regel möglichst so eingestellt, dass sie nahe der Resonanzfrequenz der zu manipulierenden Spins liegt. Abweichungen von der Mittenfrequenz von der Resonanzfrequenz werden als Off-Resonanz bezeichnet. Zur Erzeugung des B1-Feldes werden in der Hochfrequenzeinheit 7 mittels der Hochfrequenz-Sende-/Empfangs-Steuerung 7' gesteuerte Ströme an den HF-Spulen angelegt.

Weiterhin umfasst die Steuereinrichtung 9 eine Abtastwegänderungseinheit 15, mit welcher erfindungsgemäß veränderte k-Raumtrajektorien bestimmt werden können, die durch die Gradientensteuerung 5' umgesetzt werden können. Die Steuereinrichtung 9 ist insgesamt dazu ausgebildet, ein erfindungsgemäßes Verfahren durchzuführen.

Eine von der Steuereinrichtung 9 umfasste Recheneinheit 13 ist dazu ausgebildet alle für die nötigen Messungen und Bestimmungen nötigen Rechenoperationen auszuführen. Hierzu benötigte oder hierbei ermittelte Zwischenergebnisse und Ergebnisse können in einer Speichereinheit S der Steuereinrichtung 9 gespeichert werden. Die dargestellten Einheiten sind hierbei nicht unbedingt als physikalisch getrennte Einheiten zu verstehen, sondern stellen lediglich eine Untergliederung in Sinneinheiten dar, die aber auch z.B. in weniger oder auch in nur einer einzigen physikalischen Einheit realisiert sein können.

Über eine Ein-/Ausgabeeinrichtung E/A der Magnetresonanzanlage 1 können, z.B. durch einen Nutzer, Steuerbefehle an die Magnetresonanzanlage geleitet werden und/oder Ergebnisse der Steuereinrichtung 9 wie z.B. Bilddaten angezeigt werden.

Ein hierin beschriebenes Verfahren kann auch in Form eines Computerprogrammprodukts vorliegen, welches ein Programm umfasst und das beschriebene Verfahren auf einer Steuereinrichtung 9 implementiert, wenn es auf der Steuereinrichtung 9 ausgeführt wird. Ebenso kann ein elektronisch lesbarer Datenträger 26 mit darauf gespeicherten elektronisch lesbaren Steuerinformationen vorliegen, welche zumindest ein solches eben beschriebenes Computerprogrammprodukt umfassen und derart ausgestaltet sind, dass sie bei Verwendung des Datenträgers 26 in einer Steuereinrichtung 9 einer Magnetresonanzanlage 1 das beschriebene Verfahren durchführen.

**Patentansprüche**

1. Verfahren zur Aufnahme von Messdaten eines Untersuchungsobjektes mittels Magnetresonanztechnik, umfassend die Schritte:

   - Aufnehmen eines ersten Satzes an Messdaten ($MD_i$, mit i=1) eines Zielbereichs (S) des Untersuchungsobjektes (U), wobei die Messdaten unter Schalten von Hauptausleegradienten (HG) in jeweils einer Hauptausleserichtung ($G_x$) und durch Schalten von mindestens einem weiteren Auslesegradienten ($WG_y$, $WG_z$) mit modulierender Amplitude in einer auf die Hauptausleserichtung senkrecht stehenden Richtung ($G_y$, $G_z$) gleichzeitig mit jedem Hauptausleegradienten entlang erster k-Raumtrajektorien aufgenommen werden,
   - Aufnehmen mindestens eines zweiten Satzes an Messdaten ($MD_i$, mit i>1) des Zielbereichs (S) des Untersuchungsobjekts (U), wobei die Messdaten eines zweiten Satzes an Messdaten unter Schalten der gleichen Hauptausleegradienten (HG', HG'') in den jeweiligen Hauptausleserichtungen ($G_x$) wie bei dem ersten Satz an Messdaten, und durch Schalten von mindestens einem weiteren Auslesegradienten ($WG_y$', $WG_z$', $WG_y$'', $WG_z$'') mit modulierender Amplitude in einer auf die Hauptausleserichtung senkrecht stehenden Richtung ($G_y$, $G_z$) gleichzeitig mit jedem Hauptausleegradienten entlang veränderter k-Raumtrajektorien aufgenommen werden,
   - Rekonstruieren mindestens eines Bilddatensatzes (BD) aus dem ersten Satz an Messdaten ($MD_i$, mit i=1) und mindestens einem zweiten Satz an Messdaten ($MD_i$, mit i>1).

2. Verfahren nach Anspruch 1, wobei veränderte k-Raumtrajektorien eines Hauptausleegradienten eine veränderte Orientierung gegenüber ersten k-Raumtrajektorien des entsprechenden Hauptausleegradienten haben.

3. Verfahren nach einem der vorhergehenden Ansprüche, wobei veränderte k-Raumtrajektorien eine um eine Phase verschobene Modulation der Amplitude der geschalteten weiteren Auslesegradienten ($WG_y$', $WG_z$', $WG_y$'', $WG_z$'') gegenüber der Modulation der Amplitude der weiteren Auslesegradienten ($WG_y$, $WG_z$) der jeweils zugehörigen ersten k-Raumtrajektorie aufweisen.

4. Verfahren nach Anspruch 3, wobei die Phase in Abhängigkeit einer Anzahl (n-1) an zweiten Sätzen an Messdaten ($MD_i$, mit i>1) bestimmt wird.

5. Verfahren nach einem der Ansprüche 3 oder 4, wobei die Phase derart bestimmt wird, dass sich eine erste k-Raumtrajektorie und zugehörige veränderte k-Raumtrajektorien durch die jeweiligen Phasen möglichst stark voneinander unterscheiden.

6. Verfahren nach einem der Ansprüche 3 bis 5, wobei eine Reihenfolge, in welcher der erste Satz an Messdaten ($MD_i$, mit i=1) und der mindestens eine zweite Satz an Messdaten ($MD_i$, mit i>1) zeitlich nacheinander aufgenommen werden, in Abhängigkeit der bei der Aufnahme der zweiten Sätze an Messdaten ($MD_i$, mit i>1) angewendeten Phasen festgelegt wird.

7. Verfahren nach einem der vorhergehenden Ansprüche, wobei eine Modulation der Amplitude eines weiteren Auslesegradienten ($WG_y$, $WG_z$, $WG_y$', $WG_z$', $WG_y$'', $WG_z$'') sinusförmig ist.

8. Verfahren nach einem der vorhergehenden Ansprüche, wobei die Aufnahme der Messdaten ($MD_i$) mittels einer WAVE-CAIPI-Technik erfolgt.

9. Magnetresonanzanlage (1) umfassend, eine Magneteinheit (3), eine Gradienteneinheit (5), eine Hochfrequenzeinheit (7) und eine Steuereinrichtung (9) mit einer Hochfrequenz-Sende-/Empfangs-Steuerung (7') und mit einer Abtastwegänderungseinheit (15), wobei die Steuereinrichtung (9) dazu ausgebildet ist, ein Verfahren nach einem der Ansprüche 1 bis 8 auf der Magnetresonanzanlage (1) auszuführen.

10. Computerprogramm, welches direkt in einen Speicher einer Steuereinrichtung (9) einer Magnetresonanzanlage (1) ladbar ist, mit Programm-Mitteln, um die Schritte des Verfahrens nach einem der Ansprüche 1 bis 8 auszuführen, wenn das Programm in der Steuereinrichtung (9) der Magnetresonanzanlage (1) ausgeführt wird.

11. Elektronisch lesbarer Datenträger mit darauf gespeicherten elektronisch lesbaren Steuerinformationen, welche zumindest ein Computerprogramm nach Anspruch 10 umfassen und derart ausgestaltet sind, dass sie bei Verwendung des Datenträgers in einer Steuereinrichtung (9) einer Magnetresonanzanlage (1) ein Verfahren nach einem der Ansprüche 1 bis 8 durchführen.

# FIG 1

# FIG 2

# FIG 3

# FIG 4

7.1   3   7.2   1

S

U
L

5
7

7'
5'

13
9

15
S

26

E/A

**Europäisches Patentamt**
**European Patent Office**
**Office européen des brevets**

# EUROPÄISCHER RECHERCHENBERICHT

Nummer der Anmeldung

EP 19 20 0140

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | US 2013/099784 A1 (SETSOMPOP KAWIN [US] ET AL) 25. April 2013 (2013-04-25) <br> * Abbildungen 2,2C,4 * <br> * Absatz [0038] - Absatz [0043] * <br> * Absatz [0056] - Absatz [0061] * <br> ----- | 1-3,5, 7-11 | INV. <br> G01R33/48 <br> G01R33/483 <br> G01R33/561 <br> G01R33/565 <br> G01R33/56 |
| X | KERR A B ET AL: "REAL-TIME INTERACTIVE MRI ON A CONVENTIONAL SCANNER", MAGNETIC RESONANCE IN MEDICINE, JOHN WILEY & SONS, INC, US, Bd. 38, Nr. 3, 1. September 1997 (1997-09-01), Seiten 355-367, XP000699718, ISSN: 0740-3194 <br> * Abbildungen 1,2,3,4 * <br> * Abschnitt "Spiral-Interleaf Acquisition" auf Seite 358 * <br> ----- | 1-7,9-11 | |
| A | HEILER P M ET AL: "Artifact free T2*-weighted imaging at high spatial resolution using segmented EPI sequences", ZEITSCHRIFT FUER MEDIZINISCHE PHYSIK, URBAN UND FISCHER, JENA, DE, Bd. 20, Nr. 3, 1. August 2010 (2010-08-01), Seiten 166-174, XP027267775, ISSN: 0939-3889 [gefunden am 2010-08-01] <br> * Abbildung 2 * <br> * Abschnitt "Reversed Gradient Method (Method 2)" auf Seite 169 * <br> ----- | 1-11 | RECHERCHIERTE SACHGEBIETE (IPC) <br><br> G01R |

Der vorliegende Recherchenbericht wurde für alle Patentansprüche erstellt

| Recherchenort | Abschlußdatum der Recherche | Prüfer |
|---|---|---|
| München | 31. März 2020 | Durst, Markus |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

..........................................................................

& : Mitglied der gleichen Patentfamilie, übereinstimmendes Dokument

EPO FORM 1503 03.82 (P04C03)

**ANHANG ZUM EUROPÄISCHEN RECHERCHENBERICHT
ÜBER DIE EUROPÄISCHE PATENTANMELDUNG NR.**

EP 19 20 0140

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

31-03-2020

| Im Recherchenbericht angeführtes Patentdokument | Datum der Veröffentlichung | Mitglied(er) der Patentfamilie | Datum der Veröffentlichung |
|---|---|---|---|
| US 2013099784 A1 | 25-04-2013 | US 2013099784 A1<br>US 2015177353 A1 | 25-04-2013<br>25-06-2015 |

EPO FORM P0461

Für nähere Einzelheiten zu diesem Anhang : siehe Amtsblatt des Europäischen Patentamts, Nr.12/82

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 8981776 B2

**In der Beschreibung aufgeführte Nicht-Patentliteratur**

- **VON BREUER et al.** Controlled Aliasing in Parallel Imaging Results in Hiher Acceleration (CAIPIRINHA) for Multi-Slice Imaging. *Magnetic Resonance in Medicine,* 2005, vol. 53, 684-691
- **VON SETSOMPOP et al.** Blipped-Controlled Aliasing in Parallel Imaging for Simultaneous Multislice Echo Planar Imaging With Reduced g-Factor Penalty. *Magnetic Resonance in Medicine,* 2012, vol. 67, 1210-1224
- **VON BILGIC et al.** Wave-CAIPI for Highly Accelerated 3D Imaging. *Magnetic Resonance in Medicine,* 2015, vol. 73, 2152-2162
- **CHEN et al.** Self-Calibrating Wave-Encoded Variable-Density Single-Shot Fast Spin Echo Imaging. *J. Magn. Reson. Imaging,* 2018, vol. 47, 954-966
- **GAGOSKI et al.** RARE/Turbo Spin Echo Imaging with Simultaneous Multislice Wave-CAIPI. *Magn. Reson. Med.,* 2015, vol. 73, 929-938